# EUROPÄISCHE PATENTSCHRIFT

(11) **EP 0 955 667 B1**
(45) Veröffentlichungstag und Bekanntmachung des Hinweises auf die Patenterteilung: **03.09.2003**
(21) Anmeldenummer: 99106839.6
(22) Anmeldetag: 06.04.1999
(51) Int. Cl.: H01J 37/34, C23C 14/34, C23C 14/35

(54) **Target für eine Kathodenzerstäubungsvorrichtung zur Herstellung dünner Schichten**
Target for a cathode sputtering apparatus for the production of thin films
Cible pour un dispositif de pulverisation cathodique pour la production de couches minces

(30) Priorität: 05.05.1998 DE 19819933
(43) Veröffentlichungstag der Anmeldung: 10.11.1999
(73) Patentinhaber: Unaxis Deutschland Holding GmbH, 63450 Hanau (DE)
(72) Erfinder: Jung, Michael, 63755 Alzenau (DE); Krempel-Hesse, Jörg, Dr., 63683 Eckartsborn (DE); Adam, Rolf, 63450 Hanau am Main (DE)

(56) Entgegenhaltungen:
- WO-A-92/04482
- DE-A- 2 641 558
- US-A- 4 299 678
- US-A- 4 401 546
- US-A- 4 601 806
- US-A- 4 610 774
- PATENT ABSTRACTS OF JAPAN vol. 006, no. 257 (C-140), 16. Dezember 1982 (1982-12-16) & JP 57 149471 A (NIPPON SHINKU GIJUTSU KK), 16. September 1982 (1982-09-16)

## Beschreibung

Die Erfindung betrifft ein Target für eine Kathodenzerstäubungsvorrichtung zur Herstellung dünner Schichten auf einem Substrat mittels Plasma in einer Vakuumprozeßkammer, wobei das Target plattenförmig, vorzugsweise kreiszylindrisch oder parallelepiped ausgeformt ist und auf der dem Substrat abgewandten Seite des Targets ein Magnetsystem mit Quellen unterschiedlicher Polung angeordnet ist, durch die mindestens ein in sich geschlossener Tunnel aus bogenförmig gekrümmten Feldlinien gebildet wird.

Zur Herstellung dünner Schichten auf einem Substrat, vorzugsweise zur Beschichtung von Compact Discs, sind zum Stand der Technik vielfältige Lösungen bekannt.

So beschreibt beispielsweise die **EP 0 163 445** einen Targetsatz für eine Vorrichtung zum Sputtern im Vakuum mit einem ersten und zweiten Kathodenelement aus Sputtermaterial, wobei das zweite das erste umgibt und die Geometrien des ersten und zweiten Kathodenelementes so sind, daß im Vakuum Material von der emittierenden Oberfläche des zweiten Elementes, dessen Oberfläche außerhalb derjenigen des ersten Elementes liegt, gesputtert werden kann, wobei das erste Targetelement eine ringförmige Kathode ist und die anfängliche emittierende Oberfläche des zweiten Elementes kegelstumpfförmig ist.

Weiterhin ist ein kegelförmiges Sputtertarget für eine Magnetron - Sputtervorrichtung bekannt (**US 4,747,926**), im wesentlichen bestehend aus einem einstückigen Target mit zwei Oberflächenbereichen, die parallel zum zentralen Bereich eines planaren Substrates verlaufen und einem dritten geneigten Bereich, der den ersten und zweiten Bereich verbindet, einer Tragplatte, sowie Mittel zur Erzeugung eines Magnetfeldes für die Erzeugung von zwei Plasmen verschiedenen Durchmessers.

Bekannt ist auch ein Target für eine Kathodenzerstäubungsvorrichtung zur Herstellung dünner Schichten auf einem Substrat mittels Plasma in einer Vakuumprozeßkammer (**G 93 01 065.6**), bei der das Target einstückig, rotationssymmetrisch und mit einer um eine Rotationsachse angeordneten Axialbohrung ausgebildet ist, wobei die dem zu beschichtenden Substrat zugewandte und zu zerstäubende Targetvorderseite in mindestens zwei Bereiche unterteilt ist, nämlich einem ebenen, ringförmigen und zentralen Bereich, dessen Oberfläche parallel zur ebenen Targetrückseite verläuft, sowie einem äußeren Bereich, der den zentralen Bereich ringförmig umgibt und dessen Oberfläche zur Oberfläche des zentralen Bereiches so geneigt ist, daß die Dicke des Targets an seinem in Umfangsrichtung äußeren Rand größer ist als die Dicke in der Targetmitte.

Schließlich ist eine Sputterkathode nach dem Magnetron - Prinzip mit einem Target mit wenigstens zwei durchgehenden konzentrischen Vorsprüngen bekannt (**US 4,933,064**), deren Wandflächen senkrecht zur Sputterfläche verlaufen und das ein Permanent - Magnetsystem mit weichmagnetischen Polschuhen aufweist, von deren Polflächen aus Magnetfeldlinien die Sputterfläche kreuzen.

WO-A-92/04482 beschreibt die Mikrostrukturierung einer Targetoberfläche mit Rillen oder Furchen zum Zweck der Verkürzung der Burn-In-Phase eines neuen Targets in einer Sputterbeschichtungsanlage. Diese Oberflächenstrukturen weisen Dimensionen mit einer Breite and Tiefe zwischen 0.05 and 3 mm auf.

DE-A-26 41 558 ist gerichtet auf ein HF-Zerstäubungsverfahren mit einem Target, dessen Oberfläche eng mit benachbarten Rinnen oder Gruben versehen ist. Diese Massnahme dient der Erhöhung der Abscheidegeschwindigkeit durch Vergrösserung der effektiven Oberfläche des Targets. Die Tiefe der Rinnen wird exemplarisch als 1-2 mm im Abstand von 1 mm beschrieben.

Diese bekannten Targets haben den Nachteil, daß sie erstens eine relativ hohe elektrische Anschlußleistung für die Sputterstromversorgung benötigen, daß sie zweitens einen nur unbefriedigenden Wirkungsgrad beim Sputtern erreichen, d.h., daß zuviel Targetwerkstoff auf Abschirmungen und Blenden niedergeschlagen wird anstatt auf dem Substrat und daß drittens die Störanfälligkeit der Sputterstromversorgung bedingt durch Bildung von Lichtbögen (arcs) zu groß ist und es damit zu häufigen Abschaltungen der Sputterstromversorgung kommt.

Der vorliegenden Erfindung liegt die Aufgabe zugrunde, ein Target zu schaffen, dessen Standzeit besonders hoch ist, das eine besonders gleichmäßige Schichtdickenverteilung ermöglicht, das in herkömmliche Kathoden einbaubar ist und dessen Herstellung einfach und damit preiswert erfolgen kann.

Diese Aufgabe wird erfindungsgemäß durch ein Target gemäß Anspruch 1 gelöst.

Weitere Einzelheiten und Merkmale der Erfindung sind in den Patentansprüchen näher beschrieben und gekennzeichnet.

Die Erfindung läßt die verschiedensten Ausführungsmöglichkeiten zu - eine davon ist in den anhängenden Zeichnungen näher dargestellt, die in Fig. 1 den Schnitt nach den Linien A-A gemäß und in Fig. 2 das Target in der Draufsicht zeigt. Die Fig. 3a bis 3d stellen jeweils den Schnitt durch die eine Hälfte eines Targets mit zwei umlaufenden Furchen dar, wobei jeweils der Verlauf und die Ausbildung des Sputtergrabens nach einer bestimmten. Betriebszeit eingezeichnet ist.

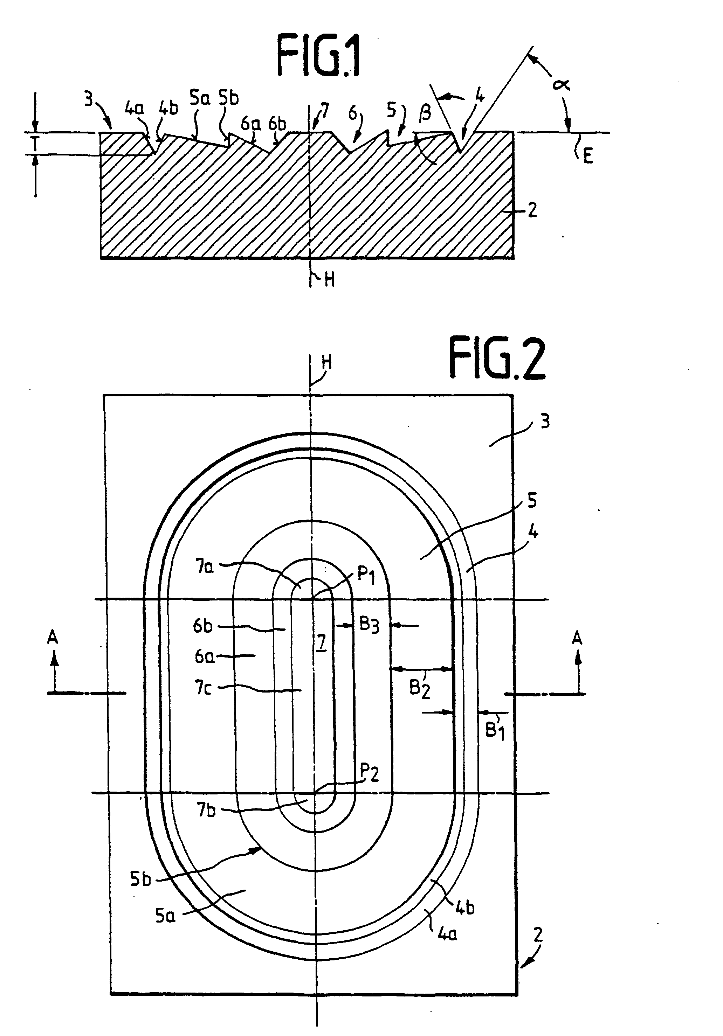

Das in den Fig. 1 und 2 dargestellte Target 2 weist auf seiner dem Substrat zugewandten Fläche 3 drei rennbahnförmige Nuten oder Furchen 4, 5, 6 auf, die so angeordnet sind, daß sie konzentrisch zueinander verlaufen, d.h. um eine gemeinsame Mittelpartie, wobei diese Mittelpartie 7 von zwei halbkreisförmigen Partien 7a, 7b und einer rechteckigen Partie 7c bestimmt ist. Die endlosen, ringförmigen Furchen 4, 5, 6 weisen jeweils zwei Böschungsflächen 4a, 4b bzw. 5a, 5b bzw. 6a, 6b auf, wobei die Böschungsflächen jeweils unterschiedliche Neigungswinkel α,...β mit der Targetebene E einschließen. Da auch die Tiefe T der einzelnen Furchen 4, 5, 6 jeweils verschieden tief bemessen ist, ergeben sich auch unterschiedliche Breitenmaße B₁, B₂, B₃ für die einzelnen Furchen 4, 5, 6.

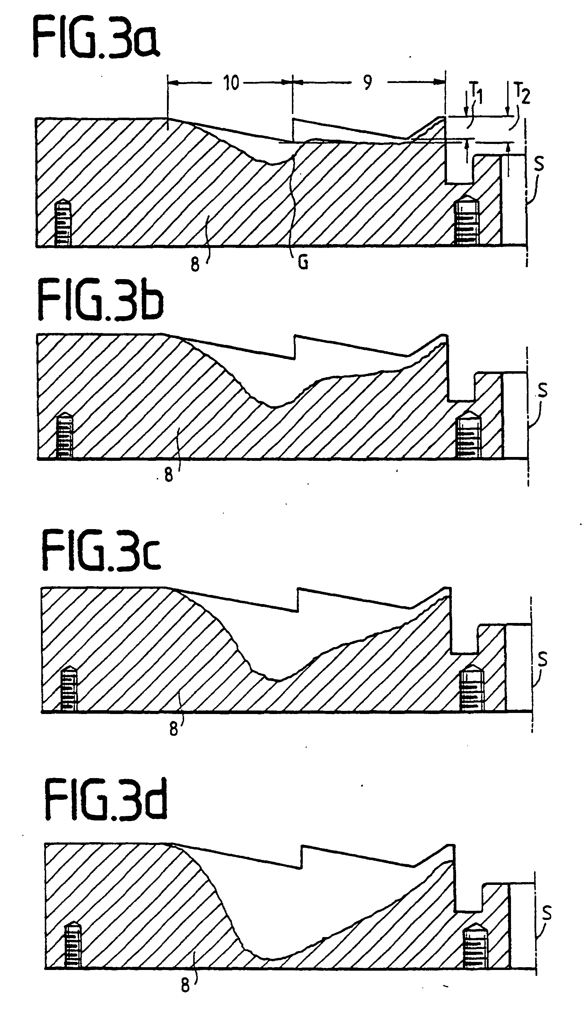

In Fig. 3a ist die eine Hälfte eines rotationssymmetrischen (eines etwa kreisringzylindrischen) Targets 8 im Querschnitt dargestellt, wobei die strichpunktierte Linie S die Rotationsachse bildet. Das Target 8 weist zwei Furchen 10, 9 auf, deren Tiefe T₁, T₂ jeweils geringfügig unterschiedlich bemessen ist. Die in Fig. 3a eingezeichnete schraffierte Fläche des Targets 8 läßt den Sputtergraben G erkennen, wie er sich nach einer Sputterzeit von 864 min herausgebildet hat. Die Fig. 3b bis 3d zeigen den Sputtergraben G nach 1739 min, 2574 min und 3477 min. Es ist klar erkennbar, daß sich der Sputtergraben G gegenüber dem typischen Grabenprofil eines herkömmlichen Targets ohne Furchen 9, 10 breiter ausgeformt hat.

Wie aus den Zeichnungen ersichtlich, entsteht
1. durch die Einteilung der Targetoberfläche in mehrere Bereiche mit unterschiedlicher Neigung infolge der gerichteten Zerstäubung auf dem Substrat eine entsprechende Schichtdickenverteilung;
2. ist in den Vertiefungen der Targetoberfläche die Zerstäubungsrate infolge des dort herrschenden stärkeren Magnetfeldes größer, wodurch sich die Form des entstehenden Sputtergrabens einstellen läßt, die ihrerseits z.B. die Targetausnutzung, die Standzeit des Targets, die Beschichtungsrate und -verteilung beeinflußt;
3. kann durch die vorstehend beschriebene Erfindung die Form des Sputtergrabens und damit die Targetausnutzung ohne Änderung der Magnetronkathode für alle Targetmaterialien verbessert werden, was zu einem erheblichen Wettbewerbsvorteil führt;
4. kann der Plasmakanal durch die Vertiefungen unabhängig vom Magnetsystem der Kathode auf dem Target verschoben werden: Legt man die Vertiefungen in die Nähe der Pratzleisten, sollten sich Belegungen auf den Pratzleisten vermeiden lassen, diese Belegungen führen beim Abplatzen zu Ausschuß;
5. wird durch den inversen Effekt (über Erhöhungen in der Targetoberfläche) ermöglicht, daß bestimmte Bereiche des Targets länger sputtern können bzw. schwächer sputtern, wodurch bekannte Vertiefungen im Sputtergraben vermieden werden, so daß sich die Tagetausnutzung bzw. - standzeit ebenfalls verbessern läßt.

## Patentansprüche

1. Target für eine Kathodenzerstäubungsvorrichtung nach dem Magnetronprinzip zur Herstellung dünner Schichten auf einem Substrat in einer Vakuumprozeßkammer, wobei das Target (2, 8) plattenförmig, vorzugsweise kreiszylindrisch oder parallelepiped ausgeformt ist und in die dem Substrat zugekehrte Fläche des Targets (2, 8) kreisringförmige oder jeweils aus zwei halbkreisförmigen und zwei geraden Abschnitten bestehende, jeweils eine geschlossene ovale Rennbahn bildende Nuten oder Furchen (4, 5, 6, 9, 10) eingeschnitten sind und mindestens zwei dieser kreisringförmigen oder rennbahnartigen ovalen Furchen konzentrisch zueinander verlaufend angeordnet sind, wobei diese mindestens zwei Furchen von zwei ebenen Böschungsflächen (4a, 4b; 5a, 5b,...) mit Neigungen (α bzw. β) zur Targetebene (E) begrenzt werden, **dadurch gekennzeichnet, dass** die mindestens zwei Furchen oder Rillen in Bezug auf die Neigung unterschiedlich sind.

2. Target nach Anspruch 1 **dadurch gekennzeichnet, daß** die auf der dem Substrat zugekehrten Fläche (3) des Targets (2, 8) vorgesehenen Furchen (4, 5, 6, 9, 10) unterschiedlich tief (T) und die die Furchen begrenzenden Böschungsflächen (44, 4b; 5a, 5b,...) unterschiedlich breit (B₁, B₂...) bemessen sind.

3. Target nach den Ansprüchen 1 und 2, **dadurch gekennzeichnet, daß** die einzelnen Furchen (4, 5, 6, bzw. 9, 10) in unterschiedlich bemessenen Abständen zur Rotationsachse (5) oder zu den Brennpunkten (P₁, P₂) bzw. zur Hauptachse (H) angeordnet sind, wobei jedoch der Abstand, den zwei parallele Furchen miteinander aufweisen, gleich groß zu bemessen ist.

## Claims

1. Target for a cathode sputtering apparatus according to the magnetron principle for the production of thin films on a substrate in a vacuum processing chamber, whereby the target (2, 8) is panel-shaped, preferably made in a circular cylindrical or parallelipiped form and cut into the surface of the target (2, 8) facing towards the substrate are grooves or furrows (4, 5, 6, 9, 10) in a circular form or consisting of two semicircular and two straight sections comprising, in each case, a closed oval racetrack shape and at least two of these circular or racetrack-shaped oval furrows are arranged mutually concentric, whereby these at least two furrows are bordered by two planar slope surfaces (4a, 4b; 5a, 5b, ...) with tilt angles (α and β) to the target plane (E), **characterised in that** the at least two furrows or grooves are different in relation to their tilt angles.

2. Target according to Claim 1, **characterised in that** the grooves (4, 5, 6, 9, 10) provided on the surface (3) of the target (2, 8) facing towards the substrate differ in depth (T) and the slope surfaces (4a, 4b; 5a, 5b) bordering the furrows are of different widths (B₁, B₂, ...).

3. Target according to Claims 1 and 2, **characterised in that** the individual furrows (4, 5, 6 and 9, 10) are arranged at different distances from the rotation axis (S) or from the foci (P₁, P₂) or from the main axis (H), whereby, however, the distance of the two parallel furrows from each other is equally large.

## Revendications

1. Cible pour un dispositif de pulvérisation cathodique suivant le principe du magnétron pour la production de couches minces sur un substrat dans une chambre à vide, ladite cible (2, 8) étant formée dune plaque de préférence cylindrique circulaire ou parallélépipédique, et des rainures ou sillons (4, 5, 6, 9, 10), qui sont annulaires ou composés chacun de deux segments semi-circulaires et de deux segments droits et qui forment une piste fermée ovale, étant gravés sur la surface dirigée vers le substrat, au moins deux de ces sillons annulaires ou en pistes de forme ovale étant concentriques l'un par rapport à l'autre, au moins ces deux sillons étant délimités par deux plans formant rampe (4a, 4b ; 5a, 5b,...) avec une inclinaison (α ou β) par rapport au plan de cible (E), **caractérisée en ce que** l'inclinaison des au moins deux sillons ou rainures est différente.

2. Cible suivant la revendication 1, **caractérisée en ce que** les sillons (4, 5, 6, 9, 10) prévus sur la surface dirigée vers le substrat (3) de la cible (2, 8) sont de profondeurs (T) différentes et **en ce que** les plans formant rampe (4a, 4b ; 5a, 5b,...) qui limitent les sillons sont de largeurs (B1, B2,...) différentes.

3. Cible suivant les revendications 1 et 2, **caractérisée en ce que** chacun des sillons (4, 5, 6 ou 9, 10) est à une distance différente de l'axe de révolution (5) ou des points focaux (P1, P2) ou de l'axe principal (H), la distance entre deux sillons parallèles étant cependant égale.
